# EUROPÄISCHE PATENTSCHRIFT

(11) **EP 1 770 795 B1**
(45) Veröffentlichungstag und Bekanntmachung des Hinweises auf die Patenterteilung: **20.06.2018**
(21) Anmeldenummer: 06019932.0
(22) Anmeldetag: 22.09.2006
(51) Int. Cl.: H01L 21/20, H01L 33/00

(54) **Epitaxiesubstrat, Verfahren zu seiner Herstellung und Verfahren zur Herstellung eines Halbleiterchips**
Substrate for epitaxy, method of fabricating it and method of fabricating a semiconductor chip
Substrat pour épitaxie, procédé de sa fabrication et procédé de fabrication d'une puce semiconductrice

(30) Priorität: 30.09.2005 DE 102005047152
(43) Veröffentlichungstag der Anmeldung: 04.04.2007
(73) Patentinhaber: OSRAM Opto Semiconductors GmbH, 93055 Regensburg (DE)
(72) Erfinder: Plößl, Andreas, 93051 Regensburg (DE); Kräuter, Gertrud, 93051 Regensburg (DE); Butendeich, Rainer, 93055 Regensburg (DE)
(74) Vertreter: Epping - Hermann - Fischer

(56) Entgegenhaltungen:
- EP-A- 0 987 741
- DE-A1- 10 361 659
- GB-A- 2 030 767
- US-A- 5 854 090
- US-A1- 2005 199 901

## Beschreibung

Die Erfindung betrifft ein Epitaxiesubstrat, insbesondere zur Herstellung von Dünnschicht-Halbleiterchips auf der Basis von III-V Halbleitern, ein Verfahren zur Herstellung des Epitaxiesubstrats sowie ein Verfahren zur Herstellung eines Dünnschicht-Halbleiterchips, insbesondere einer LED, eines Lasers oder einer IR-Diode.

Die Druckschriften EP 0 987 741 A und GB 2 030 767 A zeigen Epitaxiesubstrate.

Die Druckschrift US 2005/0199901 A1 zeigt einen Halbleiterchip und ein Herstellungsverfahren für einen solchen Halbleiterchip.

Die Druckschrift DE 103 61 659 A1 zeigt einen Halbleiterchip.

Die Verwendung von Dünnschicht-Halbleiterchips findet in den letzten Jahren insbesondere bei der Herstellung von Strahlung emittierenden Bauelementen wie LEDs und Lasern oder IR-Dioden eine immer größer werdende Bedeutung.

Ein derartiger Dünnschicht-Halbleiterchip ist beispielsweise in der DE 100 59 532 beschrieben. Bei seiner Herstellung wird eine Leuchtdiodenstruktur auf einem Epitaxiesubstrat gewachsen, danach mit einem Ersatzsubstrat verbunden und im Anschluss die Leuchtdiodenstruktur von dem Epitaxiesubstrat getrennt. Die Abtrennung des Dünnschichtfilms geschieht dabei bisher meistens, indem nach der Verbindung des Dünnschicht films mit dem Ersatzsubstrat zunächst das Epitaxiesubstrat durch Schleifen gedünnt und danach in einem Ätzschritt die Reste des Epitaxiesubstrats entfernt werden. Das ursprüngliche Epitaxiesubstrat wird dabei vollständig zerstört.

In der US 6,420,242 ist ein weiteres Verfahren zur Ablösung von Galliumnitrid-Dünnschichten beschrieben. Dabei wird eine Galliumnitridstruktur auf einem Saphirwafer abgeschieden, diese Galliumnitridschicht wird mit einem Ersatzsubstrat verbunden und danach durch Belichtung mit Laserlicht die Galliumnitridschicht erhitzt. Durch diese Erhitzung kommt es zu einer lokalen Zerstörung der Kristallstruktur im Bereich des Galliumnitrids. Die Freisetzung von gasförmigem Stickstoff in Verbindung mit einer weiteren Erhitzung zum Aufschmelzen des verbleibenden Galliums bewirkt die Ablösung des Dünnschichtfilms von dem Epitaxiesubstrat. Ein derartiges Verfahren kann allerdings bisher nur auf der Basis von Galliumnitridschichten zur Herstellung von Dünnfilmchips genutzt werden, weil die Erhitzung von Galliumnitridschichten die Freisetzung von Stickstoff in Gasform ermöglicht.
Der Erfindung liegt die Aufgabe zu Gründe, auf kostengünstige Art und Weise eine Verbesserung zu erreichen. Weiteres Ziel der Erfindung ist es, eine Ablösetechnik bei weiteren Materialsystemen, insbesondere galliumarsenidbasierten Materialsystemen zu ermöglichen.
Diese Aufgabe löst die Erfindung mit den Merkmalen der unabhängigen Patentansprüche.
Bevorzugte Ausführungsformen und Weiterbildungen der Erfindung sind Gegenstand der abhängigen Ansprüche.
Gemäß der Erfindung ist auf einem Wafer eine Opferschicht angeordnet, wobei die Opferschicht des Wafers eine Bandlücke aufweist, die kleiner ist als die Bandlücke des umgebenden Substrats. Insbesondere ist die Bandlücke der Opferschicht kleiner als die Bandlücke des Substratkristalls des Wafers. Oberhalb der Opferschicht ist eine Epitaxieschicht aufgebracht, wobei die Bandlücke der Opferschicht kleiner als die Bandlücke der Eptaxieschicht ist.

Der Wafer in Verbindung mit der Opferschicht stellt ein Epitaxiesubstrat dar. Ein derartiges Epitaxiesubstrat wird nun mit Licht, insbesondere Laserlicht bestrahlt, dessen Wellenlänge größer ist als es der Energie der Bandlücke des Wafers bzw. einer aufgewachsenen Epitaxieschicht entspricht, aber das von der Opferschicht absorbiert wird. Durch diese Bestrahlung wird die Opferschicht selektiv erhitzt. Mit Hilfe dieser Erhitzung wird die Kristallstruktur der Opferschicht gezielt zerstört.

Da die Zersetzungsprodukte stärker absorbierend sind als das umgebende Material, kann dieser Prozess selbstlimitierend geführt werden.

Mit Hilfe der Erfindung ist eine Abtrennung des Wafers von anderen aufgebrachten Schichten oder Strukturen, zum Beispiel unter Anwendung einer Dünnschichttechnologie, so möglich, dass der Wafer nicht zerstört wird und wieder verwendet werden kann.

Die vorstehend erläuterte Bestrahlung der Opferschicht wird bevorzugt bei erhöhter Umgebungstemperatur, in Vakuum, in Wasser oder in einem anderen Medium durchgeführt. Die Zersetzungsprodukte können bei erhöhter Temperatur an vorzeitiger Oxidation gehindert werden, in Vakuum effektiver aus der Trennschicht entfernt werden, in Wasser herausgelöst werden oder durch Wasserstoff zu Hydridgas konvertiert werden.

Die Erfindung sieht vorteilhaft vor, dass der Wafer Galliumarsenid enthält oder überwiegend Galliumarsenid aufweist.

Die Erfindung sieht vor, dass auf dem Epitaxiesubstrat mindestens eine Epitaxieschicht angeordnet ist. Die Opferschicht ist dabei zwischen dem Wafer und der Epitaxieschicht angeordnet. Besonders bevorzugt weist die Epitaxieschicht eine Materialzusammensetzung auf, die in ihrer Gitterkonstante den darauf abzuscheidenden Dünnschicht-Halbleiterchipstrukturen entspricht. Die Epitaxieschicht bildet weiterhin die Grundlage für die Herstellung der Dünnschicht-Halbleiterchipstruktur.

Die Erfindung sieht vor, dass die Bandlücke der Opferschicht kleiner ist als die Bandlücke von Galliumarsenid. Bei der Herstellung derartiger Galliumarsenid-Dünnschicht-Halbleiterchips soll die Bandlücke der Opferschicht kleiner als die Bandlücke von Galliumarsenid sein, damit eine gezielte selektive Erhitzung mittels Laserstrahlung ermöglicht wird. Die Erfindung sieht vor, dass das Epitaxiesubstrat zwei Ätzstoppschichten aufweist, eine oberhalb und eine unterhalb der Opferschicht. Bei Verwendung einer derartigen Ätzstoppschichtenfolge können nach einem erfolgtem Ablöseprozess der Dünnschichtstruktur bzw. des Dünnschicht-Halbleiterchips die neu entstandenen Oberflächen der Chips und des Wafers von Materialresten der Opferschicht gereinigt werden. Weiterhin sieht die Erfindung vor, dass das Epitaxiesubstrat zwei Gitteranpassungsschichten aufweist. Eine Gitteranpassungsschicht ist zwischen der Opferschicht und der darüber liegenden Epitaxieschicht angeordnet. Eine derartige Gitteranpassungsschicht verringert bzw. verhindert das Auftreten von Gitterfehlern innerhalb der Epitaxieschicht und ermöglicht dadurch das gezielte Wachstum einer Dünnschicht-Halbleiterchipstruktur oberhalb der Epitaxieschicht. Die Erfindung sieht vor, dass die Opferschicht Ge, GaAsN, GaAsSb oder InGaAs enthält. Diese Materialien sind insbesondere dafür geeignet, um eine Opferschicht innerhalb einer galliumarsenidbasierten Halbleiterstruktur zu bilden, wobei deren Bandlücke kleiner ist als die Bandlücke des umgebenden galliumarsenidbasierten Halbleitermaterials.

Eine bevorzugte Ausführungsform der Erfindung entsteht, wenn die Opferschicht Übergitter enthält. Übergitterstrukturen sind insbesondere dafür geeignet, bereits innerhalb der Opferschicht eine Gitterstrukturanpassung vorzunehmen bzw. verbessern zu können sowie die Ablöseeigenschaften bei der Zerstörung der Opferschicht zu verbessern. Eine andere bevorzugte Ausführungsform der Erfindung sieht vor, dass die Opferschicht eine direkte Bandlücke aufweist. Durch Verwendung einer direkten Bandlücke innerhalb der Opferschicht verbessert sich die Selektivität der Erhitzung der Opferschicht im Vergleich zu den weiteren-Schichtstrukturen des Epitaxiesubstrats. Zur Absorption der eingestrahlten Photonen innerhalb der Opferschicht wird bei einer direkten Bandlücke eine Wechselwirkung mit Phononen nicht benötigt. Eine andere vorteilhafte Ausführungsform der Erfindung entsteht, wenn die Gitterstruktur der Opferschicht an die Gitterstruktur des Wafers angepasst ist. Die Anpassung der Gitterstruktur der Opferschicht an die Gitterstruktur des Wafers ermöglicht es, die Verwendung von weiteren Gitterstrukturanpassungsschichten zu vermeiden.

Eine weitere vorteilhafte Ausführungsform der Erfindung entsteht, wenn auf der Wachstumsseite des Epitaxiesubstrats Gräben oder Vertiefungen angeordnet sind, welche in ihrer Tiefe mindestens bis zur Opferschicht reichen. Derartige Gräben erleichtern während des Ablöseprozesses der Dünnschicht-Halbleiterchipstrukturen vom Wafer die Ableitung eventuell auftretender Reaktionsprodukte der Opferschicht. Die im Ablösevorgang auftretenden Reaktionsprodukte während der Zerstörung der Opferschicht bzw. Auflösung der Opferschicht können sowohl gasförmige als auch flüssige Reaktionsprodukte sein. Insbesondere kann die Ablösung während der Laserbelichtung in einer vorgegebenen Atmosphäre, beispielsweise einer Wasserstoffatmosphäre, durchgeführt werden. Das Vorhandensein einer Wasserstoffatmosphäre bewirkt die Entstehung von Verbindungen der Elemente der fünften Hauptgruppe mit Wasserstoff. Diese Verbindungen sind meist gasförmig. Möglich ist jedoch auch die Verwendung anderer Atmosphären zur Erzeugung von beispielsweise wasserlöslichen Reaktionsprodukten, welche in einer feuchten Umgebung gelöst und durch die vorhandenen Gräben aus dem Bereich der Opferschicht entfernt werden können.

Eine weitere bevorzugte Ausführungsform der Erfindung entsteht, wenn auf dem Epitaxiesubstrat mindestens eine Leuchtdiodenstruktur, eine Laserstruktur oder eine IR-Dioden-Struktur angeordnet ist. Diese jeweilige Struktur kann dabei Bestandteil der Epitaxieschicht sein oder aber auch oberhalb bzw. auf der Epitaxieschicht abgeschieden werden.

Eine andere vorteilhafte Ausführungsform der Erfindung sieht vor, dass auf der mindestens einen LED- Laser oder IR-Dioden-Struktur eine Verbindungsschicht, insbesondere eine Verbindungsschicht zur Verbindung mit einem Ersatzsubstrat angeordnet ist. Durch diese Verbindungsschicht kann die spätere Dünnschicht-Halbleiterchipstruktur fest mit einem Ersatzsubstrat verbunden werden. In der Dünnschichttechnologie kommen dem Ersatzsubstrat mehrere Aufgaben zu. Beispielsweise wird das Ersatzsubstrat dazu genutzt, den Dünnschicht-Halbleiterchip von der Unterseite her zu kontaktieren, oder das Ersatzsubstrat ist dazu geeignet, den Dünnschichtfilm zu stabilisieren, damit während der Ablösung des Dünnschichtfilms von dem Epitaxiesubstrat eine Zerstörung des Dünnschicht-Halbleiterchips vermieden wird.
Eine weitere bevorzugte Ausführungsform der Erfindung sieht vor, dass erfindungsgemäße Epitaxiesubstrate zur Herstellung von LED-, Laser- oder IR-Dioden-Dünnschichtchips verwendet werden.
Zur Herstellung eines erfindungsgemäßen Epitaxiesubstrats wird vorteilhaft auf einem Wafer, insbesondere einem Galliumarsenidwafer eine Opferschicht aufgebracht. Die Erfindung beschränkt sich allerdings nicht nur auf die Verwendung von Galliumarsenidwafern, sondern umfasst alle Arten von Wafern bzw. Substraten, welche Galliumarsenid enthalten. Die Erfindung sieht vor, dass die Opferschicht mit einer Epitaxieschicht überwachsen wird, welche besonders bevorzugt III-V-Halbleiter aufweisen kann. Besonders bevorzugt handelt es sich bei den III-V-Halbleitern um galliumarsenidbasierte III-V-Halbleiter, möglich sind jedoch auch alle anderen Arten von III-V-Halbleitern.

Eine bevorzugte Ausführungsform der Erfindung sieht vor, dass die Opferschicht strukturiert wird. Bei der Strukturierung der Opferschicht kann es sich beispielsweise um das Einbringen von Grabenstrukturen bzw. Vertiefungen handeln, welche dazu geeignet sind, bei einem eventuellen späteren Ablöseschritt entstehende Reaktionsprodukte aus dem Bereich der Opferschicht zu entfernen.
Eine andere bevorzugte Ausführungsform der Erfindung sieht vor, dass das Verfahren zusätzlich den Schritt einer Strukturierung der Epitaxieschicht umfasst. Die Strukturierung der Epitaxieschicht ist insbesondere dazu geeignet, entstehende Reaktionsprodukte aus dem Bereich der Opferschicht zu entfernen.
Eine weitere vorteilhafte Ausführungsform der Erfindung sieht zur Herstellung eines LED-, Laser- oder IR-Dioden-Dünnfilmchips vor, ein Epitaxiesubstrat herzustellen und auf dessen Oberfläche oberhalb der Opferschicht eine LED-, Laser- oder IR-Dioden-Struktur aufzuwachsen, danach diese LED-, Laser- oder IR-Dioden-Struktur mit einem Ersatzsubstrat zu verbinden, den zu Grunde liegenden Wafer bzw. das zu Grunde liegende Epitaxiesubstrat mittels Laserlicht abzulösen und im Anschluss daran die darauf gewachsene LED-, Laser- oder IR-Dioden-Struktur in separate Dünnschicht-Halbleiterchips zu vereinzeln.
Die Erfindung wird nachfolgend anhand von Ausführungsbeispielen beschrieben, die in den Figuren der Zeichnungen dargestellt sind. Gleiche Elemente sind mit gleichen Bezugszeichen versehen. Es zeigen:
- Figur 1: eine schematische Querschnittsdarstellung eines Epitaxiesubstrats,
- Figur 2: eine schematische Darstellung eines erfindungsgemäßen Epitaxiesubstrats und
- Figur 3: eine bevorzugte Ausführungsform eines erfindungsgemäßen Epitaxiesubstrats mit darauf abgeschiedenen LED-Strukturen.

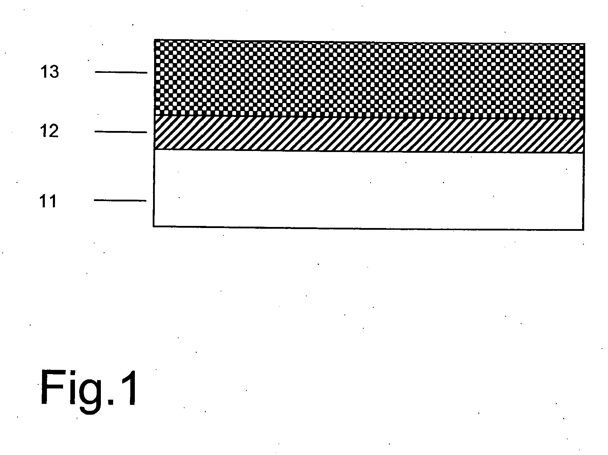

Figur 1 zeigt eine schematische Querschnittsdarstellung eines Epitaxiesubstrats, wobei auf einem Wafer 11, welcher überwiegend III-V-Halbleitermaterial, insbesondere Galliumarsenid aufweist, eine Opferschicht 12 aufgebracht ist, wobei die Opferschicht 12 eine oder mehrere der Materialien Ge, GaAsN, GaAsSb und/oder InGaAs aufweist.

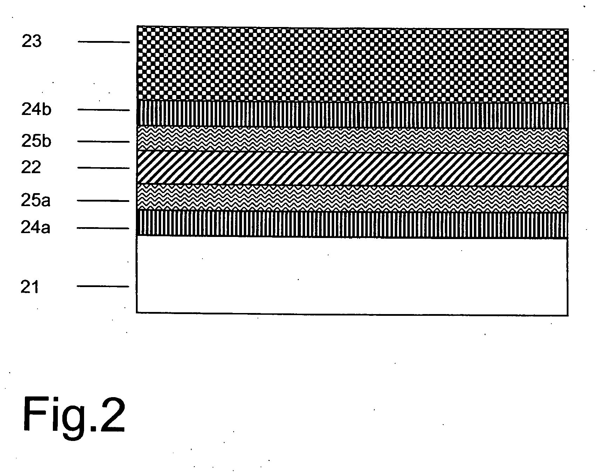

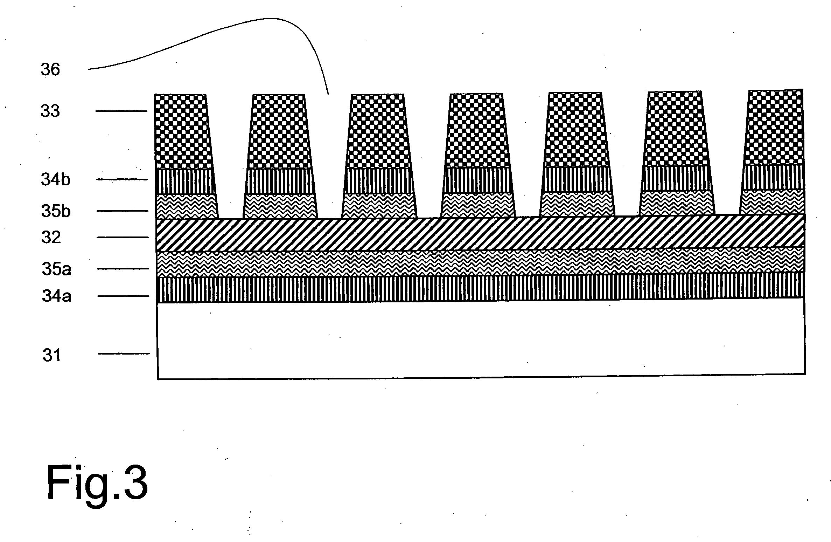

Figur 2 zeigt eine schematische Querschnittsdarstellung einer Ausführungsform der Erfindung. Auf einem Wafer 21 sind eine Ätzstoppschicht 24a, eine Gitteranpassungsschicht 25a, eine Opferschicht 22, eine weitere Gitteranpassungsschicht 25b sowie eine weitere Ätzstoppschicht 24b und eine Epitaxieschicht 23 angeordnet. Alternative Ausführungsformen können mehr Schichten aufweisen.
Die Epitaxieschicht 23 kann als Grundlage zum Wachstum von LED-, Laser- oder IR-Dioden-Strukturen dienen oder auch selbst LED-, Laser- oder IR-Dioden-Strukturen enthalten. Insbesondere sind Ätzstoppschichten 24a, 24b und Gitteranpassungsschichten 25a, 25b beidseitig der Opferschicht 22 angeordnet sein. Figur 3 zeigt eine weitere vorteilhafte Ausführungsform der Erfindung. Dabei ist auf einem Wafer 31 eine Ätzstoppschicht 34a, eine Gitteranpassungsschicht 35a, eine Opferschicht 32, eine weitere Gitteranpassungsschicht 35b und eine weitere Ätzstoppschicht 34b angeordnet. Darüber ist eine Epitaxieschicht 33 angeordnet, welche selbst beispielsweise LED-Strukturen bzw. LED-Schichten enthalten kann. Ausführungsbeispiele für erfindungsgemäße Epitaxiesubstrate können jedoch innerhalb der Epitaxieschicht 33 beliebige weitere z.B. optoelektronische Dünnschichtstrukturen enthalten, beispielsweise Laserdioden-, Laser- oder IR-Dioden-Strukturen oder Sensorenstrukturen.
Von der Wachstumsoberfläche her gesehen sind in diesem Ausführungsbeispiel Vertiefungen bzw. grabenartige Strukturen eingebracht, welche bis zur Opferschicht 32 reichen. Diese grabenartigen Strukturen 36 dienen dazu, während des Ablöseprozesses der Opferschicht entstehende Reaktionsprodukte zu entfernen. In besonders bevorzugten Ausführungsformen markieren diese Grabenstrukturen 36 gemäß der Dünnschichttechnologie die Bereiche, in denen nach der Verbindung der Epitaxieschicht 33 mit dem versteifenden Träger- bzw. Ersatzsubstrat und der Ablösung des Wachstumssubstrats 31 eine Durchtrennung vorgenommen wird, um eine Vereinzelung in mehrere Dünnschicht-Halbleiterchips zu erreichen.

## Patentansprüche

1. III-V-Halbleiter aufweisendes Epitaxiesubstrat mit einer auf einem Wafersubstrat (11; 21; 31) aufgebrachten Opferschicht (12; 22; 32), deren Bandlücke kleiner ist als die Bandlücke des Substratkristalls des Wafersubstrats (11; 21; 31), **dadurch gekennzeichnet, dass**
der Wafer (11; 21; 31) GaAs enthält, die Bandlücke der Opferschicht (12; 22; 32) kleiner ist als die Bandlücke von GaAs, die Opferschicht (12; 22; 32) Ge, GaAsN, GaAsSb oder InGaAs enthält, und das Epitaxiesubstrat eine Ätzstoppschicht (24a; 34a) aufweist, wobei die Ätzstoppschicht (24a; 34a) unterhalb der Opferschicht (22; 32) angeordnet ist,
wobei das Epitaxiesubstrat
- mindestens eine Epitaxieschicht (23, 33) aufweist, deren Bandlücke größer als die Bandlücke der Opferschicht (22, 32) ist,
- eine Ätzstoppschicht (24a; 34a) aufweist, die zwischen dem Wafersubstrat (21, 31) und der Opferschicht (22, 32) angeordnet ist,
- eine weitere Ätzstoppschicht (24b, 34b) aufweist, die zwischen der Opferschicht (22, 32) und der darüberliegenden Epitaxieschicht (23, 33) angeordnet ist,
- eine Gitteranpassungsschicht (25a, 35a) aufweist, die zwischen der Ätzstoppschicht (24a; 34a) und der Opferschicht (22, 32) angeordnet ist, und
- eine weitere Gitteranpassungsschicht (25b, 35b) aufweist, die zwischen der Opferschicht (22, 32) und der weiteren Ätzstoppschicht (24b, 34b) angeordnet ist.

2. Epitaxiesubstrat nach dem vorangegangenen Ansprüche,
**dadurch gekennzeichnet, dass** das Epitaxiesubstrat Übergitter enthält.

3. Epitaxiesubstrat nach einem der vorangegangenen Ansprüche,
**dadurch gekennzeichnet, dass**
die Opferschicht (12; 22; 32) eine direkte Bandlücke aufweist.

4. Epitaxiesubstrat nach einem der vorangegangenen Ansprüche außer Anspruch 3,
**dadurch gekennzeichnet, dass**
die Gitterstruktur der Opferschicht (12; 22; 32) an die Gitterstruktur des Wafers (11; 21; 31) angepasst ist.

5. Epitaxiesubstrat nach einem der vorangegangenen Ansprüche,
**dadurch gekennzeichnet, dass**
auf der Wachstumsseite des Epitaxiesubstrates Gräben oder Vertiefungen (36) angeordnet sind, welche in ihrer Tiefe mindestens bis zur Opferschicht (32) reichen.

6. Epitaxiesubstrat nach einem der vorangegangenen Ansprüche,
**dadurch gekennzeichnet, dass**
auf dem Epitaxiesubstrat mindestens eine Leuchtdiodenstruktur angeordnet ist.

7. Epitaxiesubstrat gemäß Anspruch 5,
**dadurch gekennzeichnet, dass**
auf der mindestens einen LED-Struktur eine Verbindungsschicht zur Verbindung mit einem Ersatzsubstrat angeordnet ist.

8. Verfahren zur Herstellung eines Epitaxiesubstrats gemäß einem der Ansprüche 1 bis 7 umfassend die Schritte:
- Bereitstellung eines GaAs aufweisenden Wafers (11; 21; 31),
- Aufbringen einer Opferschicht (12; 22; 32), deren Bandlücke kleiner ist als die Bandlücke des Substratkristalls des Wafers (11; 21; 31).

9. Verfahren gemäß Anspruch 8, **gekennzeichnet durch** ein Überwachsen der Opferschicht (12; 22; 32), mit einer Epitaxieschicht (13; 23; 33), die III-V-Halbleiter aufweist.

10. Verfahren gemäß einem der Ansprüche 8 oder 9,
**dadurch gekennzeichnet, dass** die Opferschicht (12; 22; 32) strukturiert wird.

11. Verfahren nach Anspruch 9,
**dadurch gekennzeichnet, dass**
die Epitaxieschicht (13; 23; 33) strukturiert wird.

12. Verfahren zur Herstellung mindestens eines LED-Dünnfilmchips, umfassend die Schritte,
- Herstellung eines Epitaxiesubstrats unter Verwendung eines Verfahrens gemäß einem der Ansprüche 8 bis 11 mit einer auf einem Wafersubstrat (11; 21; 31) aufgebrachten Opferschicht (12; 22; 32), deren Bandlücke kleiner ist als die Bandlücke des Substratkristalls des Wafersubstrats (11; 21; 31),
- Wachsen mindestens einer LED-Struktur auf dem Epitaxiesubstrat,
- Verbinden der LED-Struktur mit einem Ersatzsubstrat,
- Ablösen des Wafersubstrats (11; 21; 31) durch zumindest teilweise thermische Zerstörung der Opferschicht (12; 22; 32),
- Vereinzeln der mindestens einen LED-Struktur.

## Claims

1. A III-V semiconductor-comprising epitaxial substrate having a sacrificial layer (12; 22; 32) deposited on a wafer substrate (11; 21; 31), a bandgap of said sacrificial layer (12; 22; 32) being smaller than the bandgap of the substrate crystal of the wafer substrate (11; 21; 31),
**characterized in that**
the wafer (11; 21; 31) contains GaAs, the band gap of the sacrificial layer (12; 22; 32) is smaller than the band gap of GaAs, the sacrificial layer (12; 22; 32) contains Ge, GaAsN, GaAsSb or InGaAs, and the epitaxial substrate comprises an etch stop layer (24a; 34a), wherein the etch stop layer (24a; 34a) is disposed below the sacrificial layer (22; 32),
wherein the epitaxial substrate
- comprises at least one epitaxial layer (23, 33) whose band gap is greater than the band gap of the sacrificial layer (22, 32),
- comprises an etch stop layer (24a, 34a), which is disposed between the wafer substrate (21, 31) and the sacrificial layer (22, 32),
- comprises a further etching stop layer (24b, 34b), which is arranged between the sacrificial layer (22, 32) and the overlying epitaxial layer (23, 33),
- comprises a lattice matching layer (25a, 35a), which is disposed between the etch stop layer (24a, 34a) and the sacrificial layer (22, 32), and
- comprises a further lattice matching layer (25b, 35b), which is arranged between the sacrificial layer (22, 32) and the further etching stop layer (24b, 34b).

2. An epitaxial substrate according to the preceding claim,
**characterized in that**
the epitaxial substrate contains superlattices.

3. An epitaxial substrate according to one of the preceding claims,
**characterized in that**
the sacrificial layer (12; 22; 32) has a direct bandgap.

4. An epitaxial substrate according to any one of the preceding claims other than claim 3,
**characterized in that**
the lattice structure of the sacrificial layer (12; 22; 32) is adapted to the lattice structure of the wafer (11; 21; 31) .

5. An epitaxial substrate according to one of the preceding claims,
**characterized in that**
trenches or depressions (36) are arranged on the growth side of the epitaxial substrate, which extend in depth at least as far as the sacrificial layer (32).

6. An epitaxial substrate according to one of the preceding claims,
**characterized in that**
at least one light-emitting diode structure is arranged on the epitaxial substrate.

7. Epitaxial substrate according to claim 5,
**characterized in that**
on the at least one LED-structure, a connection layer for connection to a replacement substrate is arranged.

8. Process for producing an epitaxial substrate according to one of claims 1 to 7, comprising the steps:
- providing a GaAs-comprising wafer (11, 21, 31),
- applying a sacrificial layer (12; 22; 32) whose band gap is smaller than the band gap of the substrate crystal of the wafer (11; 21; 31).

9. Method according to claim 8,
**characterized in**
an overgrowth of the sacrificial layer (12; 22; 32) with an epitaxial layer (13; 23; 33) which comprises III-V semiconductors.

10. Method according to one of the claims 8 or 9,
**characterized in that**
the sacrificial layer (12; 22; 32) is structured.

11. Method according to claim 9,
**characterized in that**
the epitaxial layer (13; 23; 33) is structured.

12. Method for producing at least one LED thin-film chip, comprising the steps of
- production of an epitaxial substrate using a method according to one of the claims 8 to 11, having a sacrificial layer (12; 22; 32) applied to a wafer substrate (11; 21; 31), a band gap of said sacrificial layer (12; 22; 32) being smaller than the band gap of the substrate crystal of the wafer substrate (11 21, 31),
- growing at least one LED-structure on the epitaxial substrate,
- connecting the LED-structure to a replacement substrate,
- detaching the wafer substrate (11, 21, 31) by at least partial thermal destruction of the sacrificial layer (12, 22, 32),
- singulating the at least one LED-structure.

## Revendications

1. Substrat d'épitaxie présentant des semi-conducteurs III-V, comprenant une couche sacrificielle (12 ; 22 ; 32) appliquée sur un substrat de plaquette (11 ; 21 ; 31), dont la bande interdire est plus petite que la bande interdire du cristal de substrat du substrat de plaquette (11 ; 21 ; 31),
**caractérisé en ce que**
la plaquette (11 ;21 ; 31) contient GaAs, **en ce que** la bande interdire de la couche sacrificielle (12 ; 22 ; 32) est plus petite que la bande interdire de GaAs, **en ce que** la couche sacrificielle (12 ; 22 ; 32) contient Ge, GaAsN, GaAsSb ou InGaAs, et **en ce que** le substrat d'épitaxie présente une couche d'arrêt d'attaque (24a ; 34a), la couche d'arrêt d'attaque (24a ; 34a) étant disposée en dessous de la couche sacrificielle (22 ; 32), le substrat d'épitaxie présentant
- au moins une couche épitaxiale (23, 33) dont la bande interdire est plus grande que la bande interdire de la couche sacrificielle (22, 32),
- une couche d'arrêt d'attaque (24a ; 34a) qui est disposée entre le substrat de plaquette (21, 31) et la couche sacrificielle (22, 32),
- une couche d'arrêt d'attaque supplémentaire (24b, 34b) qui est disposée entre la couche sacrificielle (22, 32) et la couche épitaxiale (23, 33) située par-dessus,
- une couche d'adaptation de réseau (25a, 35a) qui est disposée entre la couche d'arrêt d'attaque (24a, 34a) et la couche sacrificielle (22, 32), et
- une couche d'adaptation de réseau supplémentaire (25b, 35b) qui est disposée entre la couche sacrificielle (22, 32) et la couche d'arrêt d'attaque supplémentaire (24b, 34b).

2. Substrat d'épitaxie selon la revendication précédente,
**caractérisé en ce que**
le substrat d'épitaxie contient des super réseaux.

3. Substrat d'épitaxie selon l'une quelconque des revendications précédentes,
**caractérisé en ce que**
la couche sacrificielle (12 ; 22 ; 32) présente une bande interdite directe.

4. Substrat d'épitaxie selon l'une quelconque des revendications précédentes, excepté la revendication 3,
**caractérisé en ce que**
la structure de réseau de la couche sacrificielle (12 ; 22 ; 32) est adaptée à la structure de réseau de la plaquette (11 ; 21 ; 31).

5. Substrat d'épitaxie selon l'une quelconque des revendications précédentes,
**caractérisé en ce que**
sur le côté de croissance du substrat d'épitaxie sont disposés des tranchées ou des approfondissements (36), lesquels arrivent au moins jusqu'à la couche sacrificielle (32) dans leur profondeur.

6. Substrat d'épitaxie selon l'une quelconque des revendications précédentes,
**caractérisé en ce qu'**
au moins une structure à diode luminescente est disposée sur le substrat d'épitaxie.

7. Substrat d'épitaxie selon la revendication 5,
**caractérisé en ce qu'**
une couche de liaison destinée à la liaison à un substrat de substitution est disposée sur l'au moins une structure à LED.

8. Procédé de fabrication d'un substrat d'épitaxie selon l'une quelconque des revendications 1 à 7, comprenant les étapes :
- fourniture d'une plaquette (11 ; 21 ; 31) présentant GaAs,
- application d'une couche sacrificielle (12 ; 22 ; 32) dont la bande interdite est plus petite que la bande interdite du cristal de substrat de la plaquette (11 ; 21 ; 31).

9. Procédé selon la revendication 8,
**caractérisé par**
une surcroissance de la couche sacrificielle (12 ; 22 ; 32) avec une couche épitaxiale (13 ; 23 ; 33) qui présente des semi-conducteurs III-V.

10. Procédé selon l'une quelconque des revendications 8 ou 9,
**caractérisé en ce que**
la couche sacrificielle (12 ; 22 ; 32) est structurée.

11. Procédé selon la revendication 9,
**caractérisé en ce que**
la couche d'épitaxie (13 ; 23 ; 33) est structurée.

12. Procédé de fabrication d'au moins une puce à couche mince à LED, comprenant les étapes,
- fabrication d'un substrat d'épitaxie en utilisant un procédé selon l'une quelconque des revendications 8 à 11, comprenant une couche sacrificielle (12 ; 22 ; 32) appliquée sur un substrat de plaquette (11 ; 21 ; 31), dont la bande interdite est plus petite que la bande interdite du cristal de substrat du substrat de plaquette (11 ; 21 ; 31),
- croissance sur le substrat d'épitaxie d'au moins une structure à LED,
- liaison de la structure à LED à un substrat de substitution,
- détachement du substrat de plaquette (11 ; 21 ; 31) par destruction au moins partiellement thermique de la couche sacrificielle (12 ; 22 ; 32),
- séparation de l'au moins une structure à LED.
